# EUROPÄISCHE PATENTSCHRIFT

(11) **EP 0 482 546 B1**
(45) Veröffentlichungstag und Bekanntmachung des Hinweises auf die Patenterteilung: **13.03.1996**
(21) Anmeldenummer: 91117912.5
(22) Anmeldetag: 21.10.1991
(51) Int. Cl.: H01S 3/043, H01L 33/00, H01L 23/44, F25D 19/00

(54) **Kühlvorrichtung für optische und/oder elektronische Elemente**
Cooling device for optical and/or electronic elements
Appareil de refroidissement pour composants optiques et/ou électroniques

(30) Priorität: 20.10.1990 DE 4033383
(43) Veröffentlichungstag der Anmeldung: 29.04.1992
(73) Patentinhaber: FRAUNHOFER-GESELLSCHAFT ZUR FÖRDERUNG DER ANGEWANDTEN FORSCHUNG E.V., D-80636 München (DE)
(72) Erfinder: Riedel, Wolfgang Julius, W-7844 Neuenburg (DE); Knothe, Manfred, W-7800 Freiburg i. Br. (DE)

(56) Entgegenhaltungen:
- DE-A- 2 352 251
- GB-A- 1 110 811
- GB-A- 1 361 505
- US-A- 3 386 256
- PATENT ABSTRACTS OF JAPAN vol. 7, no. 99 (E-172)(1244) 27. April 1983 & JP-A-58 021 388 ( FUJITSU KK ) 8 Februar 1983
- OPTICAL ENGINEERING. Bd. 26, Nr. 9, September 1987, BELLINGHAM US Seiten 902 - 910; G.BEAL ET AL.: 'THOMSON CSF FRAME TRANSFER CHARGE COUPLED DEVICE IMAGERS : DESIGN AND EVALUATION AT VERY LOW LEVEL FLUX'

## Beschreibung

### Technisches Gebiet

Die Erfindung betrifft eine Vorrichtung zur Kühlung von Elementen wie optischen und/oder elektronischen Komponenten, z.B. Diodenlasern, und/oder sonstigen Proben mit einem Vorratsbehälter für eine Kryoflüssigkeit, die einer Verdampfungskammer zugeführt wird, in der sie vollständig verdampft, wodurch dem Element Wärme entzogen wird.

### Stand der Technik

Zur Kühlung von Diodenlasern, z.B. Bleisalz-Diodenlasern, wie sie üblicherweise in Laserspektrometern für den Infrarotbereich eingesetzt werden, werden für den Temperaturbereich bis herab zu 20 K typischerweise Kältemaschinen mit geschlossenem Heliumkreislauf eingesetzt. Diese oder andere periodisch arbeitende Kältemaschinen erzeugen mechanische Vibrationen, die sich möglichst wenig auf den Diodenlaser sowie den zugehörigen optischen Aufbau übertragen sollen. Hierzu sind umfangreiche Maßnahmen notwendig, wie sie z.B. in der DE-PS 36 39 881 oder der DE-PS 34 45 674 beschrieben sind.

Darüberhinaus werden zur Kühlung von Diodenlasern auf Temperaturen oberhalb von 80 K häufig Kühler mit flüssigem Stickstoff als Kryoflüssigkeit benutzt, bei denen der zu kühlende Diodenlaser über einen definierten Wärmewiderstand mit dem Flüssigstickstoffbehälter verbunden ist. Die jeweils gewünschte Arbeitstemperatur, die die genaue Laserwellenlänge bestimmt, wird dabei durch eine geregelte elektrische Heizung des Lasergehäuses eingestellt. Dabei muß jedoch der Wärmewiderstand der Anwendung im Einzelfall angepaßt werden. Bei einem kleinen eingebauten Wärmewiderstand lassen sich zwar leicht tiefe Temperaturen nahe dem Siedepunkt erreichen, bei höheren Temperaturen steigt jedoch der Kühlmittelbedarf sehr stark an, wodurch die Standzeit des Kühlers erheblich reduziert wird. Bei großem eingebauten Wärmewiderstand hingegen ist bei hohen Temperaturen der Kühlmittelverbrauch zwar gering, tiefe Temperaturen lassen sich jedoch nicht mehr erreichen.

Weiter ist bekannt, zur Messung von Proben bei tiefen Temperaturen, diese innerhalb eines Verdampferkryostaten auf die gewünschte Temperatur abzukühlen. Diese Verdampferkryostaten benötigen Regelventile, Vedampfungskörper und Pumpe und sind damit technisch sehr aufwendig.

Weiterhin ist in der US 3 386 256 eine Kühlvorrichtung offenbart, bei der ein zu kühlendes Element auf einem Wärmeleitelement angeordnet ist, welches über einen flexiblen Schlauch mit einem Kühlflüssigkeits-Vorratsbehälter verbunden ist. Der Schlauch ist doppelwandig unter Verwendung von Distanzelementen ausgeführt. Im inneren Schlauch befindet sich ein Drahtgeflecht, das an einem Ende mit dem Wärmeleitelement verbunden ist und am gegenüberliegenden Ende in ein Rohr übergeht, das in den Kühlflüssigkeitsvorrat hineinragt. Der Kühlflüssigkeits-Vorratsbehälter ist gasdicht verschlossen. Durch den sich im Innern des Vorratsbehälters bildenden Dampfdruck oder zusätzlich durch externe Druckbeaufschlagung wird die Kühlflüssigkeit durch das Rohr und das Drahtgeflecht zum Wärmeleitelement bewegt, wobei sie ganz oder teilweise verdampft und anschließend über ein Steuerventil entweicht.

Aus dem Stand der Technik (DE 24 21 102, DE 23 52 251) ist eine einfachere Vorrichtung bekannt, bei der sich eine Kryoflüssigkeit in einem thermisch isolierten Vorratsbehälter befindet, der über ein wärmeisolierendes Element mit einer darunterliegenden Verdampfungskammer in Verbindung steht, und bei der über den Rand des wärmeisolierenden Elementes Kryoflüssigkeit in die Verdampfungskammer eintropft und dort verdampft. Dabei bildet sich eine quasistatische Dampfblase, die unter Überdruck steht und die eine Phasengrenze zwischen der Kryoflüssigkeit und der Dampfblase an dem als Drosselstelle wirkenden Zwischenraum zwischen dem Rand des wärmeisolierenden Elementes und der Gefäßwand bewirkt. Zur Variation der Temperatur innerhalb dieser quasistatischen Dampfblase wird mittels einer elektrischen Heizung Wärme zugeführt, wobei die elektrische Heizung entweder direkt in der Verdampfungskammer angeordnet ist (DE 24 21 102) oder in den gut wärmeleitenden Boden der Verdampfungskammer eingebaut ist. (DE 23 52 251). Die Kühlleistung und damit der Kühlmittelverbrauch einer solchen Anordnung ist nicht wohl definiert und auch nicht definiert einstellbar. Die Fertigung ist wegen der verschiedenartigen Materialien technisch aufwendig.

### Darstellung der Erfindung

Der Erfindung liegt das Problem zu Grunde, eine Vorrichtung zur Kühlung von Elementen wie optischen und/oder elektronischen Komponenten und/oder sonstigen Proben, insbesondere von Diodenlasern anzugeben, mit der die Betriebstemperatur der zu kühlenden Elemente gleichzeitig vibrationsfrei und in einfacher Art und Weise in einem weiten Temperaturbereich einstellbar ist, ohne daß es erforderlich wäre, bauliche Veränderungen, wie beispielsweise das Auswechseln von Wärmewiderständen, vorzunehmen, und gleichzeitig den Kühlmittelbedarf gering zu halten.

Zwei unabhängige Lösungen dieses Problems sind in den Ansprüchen 1 und 4 angegeben. Vorteilhafte Weiterbildungen der Erfindung sind mit den Merkmalen der Unteransprüche 2 und 3 sowie 5 - 18 gekennzeichnet.

Die Vorteile der Erfindung bestehen insbesondere darin, daß einerseits durch die Kühlung mittels einer verdampfenden Kryoflüssigkeit im Gegensatz zu periodisch arbeitenden Kältemaschinen keine Vibrationen erzeugt werden, und somit auch keine umfangreiche Maßnahmen zur Verhinderung der Übertragung der Vibrationen auf die zu kühlenden Elemente, insbesondere Diodenlaser einschließlich dem zugehörigen Aufbau, notwendig sind, und daß sich andererseits die Betriebstemperatur der Elemente bei möglichst geringem Kryoflüssigkeitsbedarf und somit einer langen Standzeit des Kühlers in einem weiten Temperaturbereich variieren läßt.

Die Einstellung der Kühlleistung und somit die Betriebstemperatur ist in einfacher Weise allein über die in der Kryoflüssigkeit angeordnete Drossel möglich, da die hydrostatische Druckdifferenz durch die feste Position der Drossel im unteren Bereich des Kryoflüssigkeitsvorrats einerseits und durch das konstante Niveau der Kryoflüssigkeit in der Verdampfungskammer andererseits konstant ist und somit nicht von der Höhe des Kryoflüssigkeitsvorrates abhängt. Die Zufuhr von Kryoflüssigkeit in die Verdampfungskammer erfolgt selbsttätig aufgrund der Schwerkraft.

Die Weiterbildung der Erfindung nach den Ansprüchen 3 und 4 sowie weitere spezielle Ausführungsformen entsprechend den weiteren Unteransprüchen ermöglichen es, daß durch die Trennung von Verdampfungskammer und Kryoflüssigkeitsvorrat das obere Ende der Verdampfungskammer tiefergelegt werden kann als das unterste Niveau des Kryoflüssigkeitsvorrates und daß somit, wenn die Kryoflüssigkeitszuleitung vom Grund des Kryoflüssigkeitsvorrates ausgeht, der gesamte Vorrat an Kryoflüssigkeit zur Verdampfung zur Verfügung steht.

### Kurze Beschreibung der Zeichnungen

Nachfolgend wird die Erfindung in drei Ausführungsbeispielen mit jeweils einer Zeichnung noch näher beschrieben. Als Kryoflüssigkeit soll im folgenden flüssiger Stickstoff dienen. Das Wärmeleitelement soll als Kühlfinger ausgebildet sein und als zu kühlendes Element wird ein Diodenlaser verwendet.

Es zeigen:

Fig. 1 eine erfindungsgemäße Kühlvorrichtung in Schnittdarstellung.

Fig. 2 eine Weiterbildung der erfindungsgemäßen Kühlvorrichtung in Schnittdarstellung.

Fig. 3 eine andere Weiterbildung der erfindungsgemäßen Kühlvorrichtung in Schnittdarstellung.

### Bester Weg zur Ausführung der Erfindung

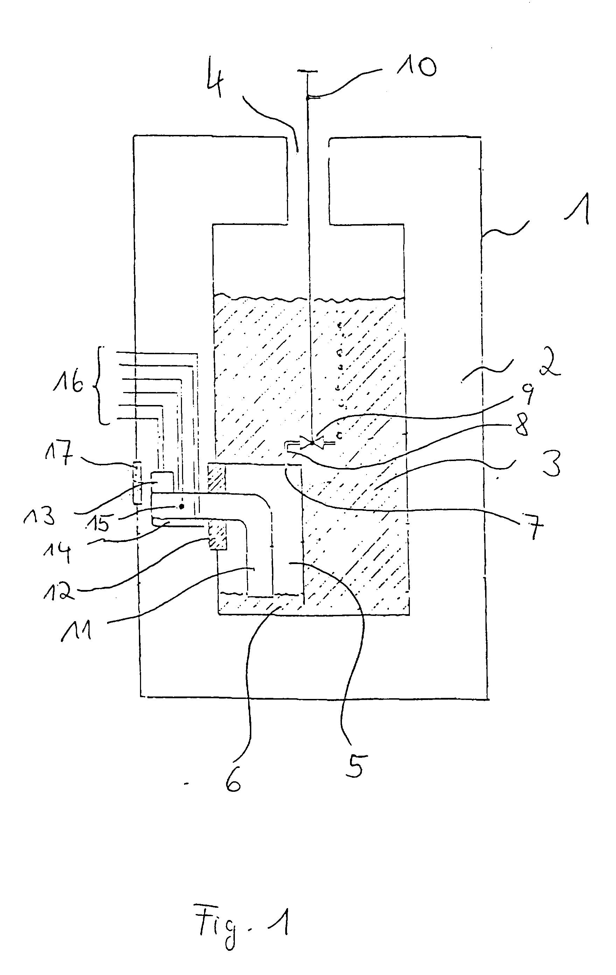

Die in Fig. 1 geoffenbarte Kühlvorrichtung besteht aus einem Vorratsbehälter 1 für den flüssigen Stickstoff, der nach Art eines Dewargefäßes ausgebildet ist, so daß zwischen den Wänden dieses Dewargefäßes ein Isoliervakuum 2 besteht. Der Stickstoffvorrat 3 wird über eine Einfüllöffnung 4 in das Innere des Vorratsbehälters 1 eingefüllt. Im Inneren des Stickstoffvorrates 3 befindet sich eine Verdampfungskammer 5, die eine untere Öffnung 6 (Eintrittsöffnung) aufweist, über die der flüssige Stickstoff in die Verdampfungskammer 5 eindringen kann, und eine obere Öffnung 7 (Austrittsöffnung), über die der Dampf über eine Dampfableitung 8 und eine Drossel 9 in den Stickstoffvorrat 3 entweicht. Die Betätigung der Drossel 9 erfolgt mittels einer mechanischen Vorrichtung 10 durch die Einfüllöffnung 4. Innerhalb der Verdampfungskammer 5 befindet sich ein nach unten gebogener aus gut wärmeleitendem Material bestehender Kühlfinger 11, der von der Verdampfungskammer 5 in das Isoliervakuum 2 hineinragt, und dabei mittels einer Wärmeisolierung 12 thermisch gegen die Innenwand des Dewargefäßes isoliert ist. An dem sich im Isoliervakuum 2 befindlichen Ende des Kühlfingers 11 sind der Diodenlaser 13 mit der dazugehörigen elektrischen Heizung 14 sowie ein Temperatursensor 15 angebracht und werden über elektrische Zuführungen 16 betrieben. Die von dem Diodenlaser 13 emittierte elektromagnetische Strahlung wird über ein Fenster 17 aus der Kühlvorrichtung ausgekoppelt. Die vom Diodenlaser 13 und der Heizung 14 erzeugte Wärme wird über den Kühlfinger 11 in die Verdampfungskammer 5 abgeführt. Der durch die untere Öffnung 6 in die Verdampfungskammer 5 eindringende flüssige Stickstoff benetzt den Kühlfinger 11 und verdampft aufgrund der vom Kühlfinger 11 zugeführten Wärmeenergie. Dadurch, daß in der Dampfableitung 8 eine Drossel 9 eingebaut ist, wird das Ausströmen des Stickstoffgases begrenzt, und es baut sich in der Verdampfungskammer 5 ein Überdruck auf, der den Pegel des flüssigen Stickstoffs in der Verdampfungskammer 5 zurückhält. Flüssiger Stickstoff kann nur in dem Maße über die untere Öffnung 6 in die Verdampfungskammer 5 nachfließen, wie gasförmiger Stickstoff über die Drossel 9 ausströmt. Die ausströmende Gasmenge ergibt sich aus der Größe der Drossel 9 und der hydrostatischen Druckdifferenz zwischen dem Niveau des flüssigen Stickstoffs in der Verdampfungskammer 5 und der Höhe der Ausströmöffnung des verdampften flüssigen Stickstoffs in den Stickstoffvorrat 3. Das Niveau des flüssigen Stickstoffs in der Verdampfungskammer 5 pegelt sich dabei selbständig auf das untere Ende des Kühlfingers 11 ein, wodurch die hydrostatische Druckdifferenz konstant bleibt. Die Menge des über die Drossel 9 ausströmenden Gases und damit die Menge des verdampften flüssigen Stickstoffs und somit die Kühlleistung hängen somit nur noch von der Größe der Drossel 9 ab und nicht mehr von der Temperatur des Kühlfingers 11 mit dem Diodenlaser 13. Damit läßt sich mit der Drossel 9 die gewünschte Kühlleistung einstellen. Über die durch die Einfüllöffnung 4 führende mechanische Vorrichtung 10 kann die Drossel 9 und somit auch die Kühlleistung während des Betriebes verstellt werden. Dabei kann die Drossel 9 z.B. als Nadelventil ausgeführt sein. In der Regel wird bei voreingestellter Drossel 9 und somit bei vorgegebener Kühlleistung die gewünschte Betriebstemperatur des Diodenlasers 13 durch Variation der Heizleistung geregelt. Selbstverständlich ist auch der umgekehrte Fall möglich, daß bei gegebener Wärmelast die gewünschte Betriebstemperatur des Diodenlasers 13 durch Variation der Kühlleistung, d.h. durch Verstellen der Drossel 9, geregelt wird.

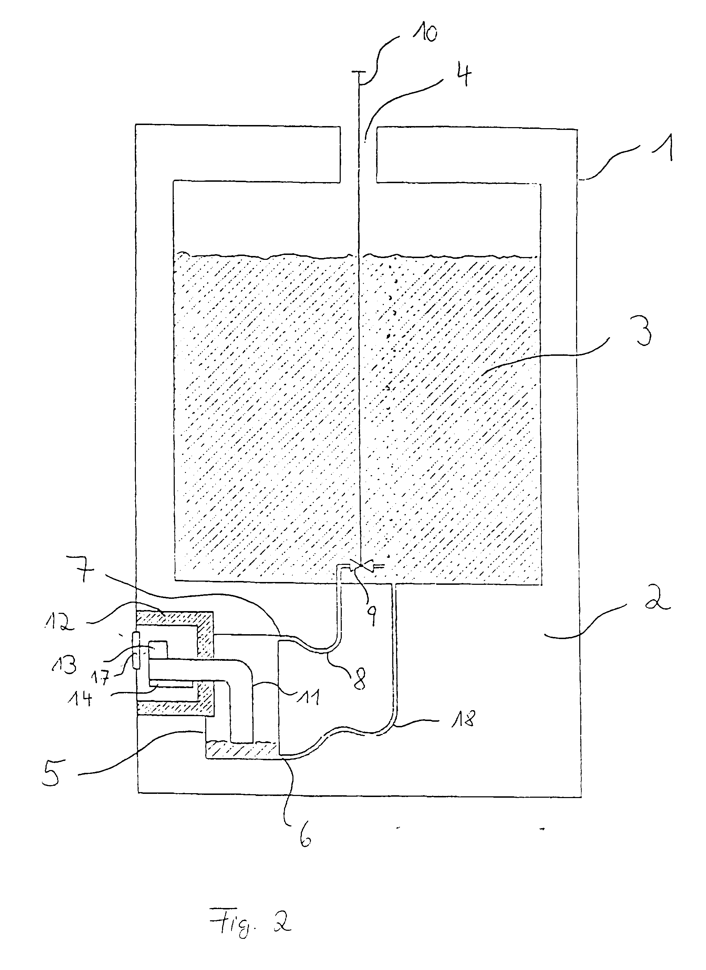

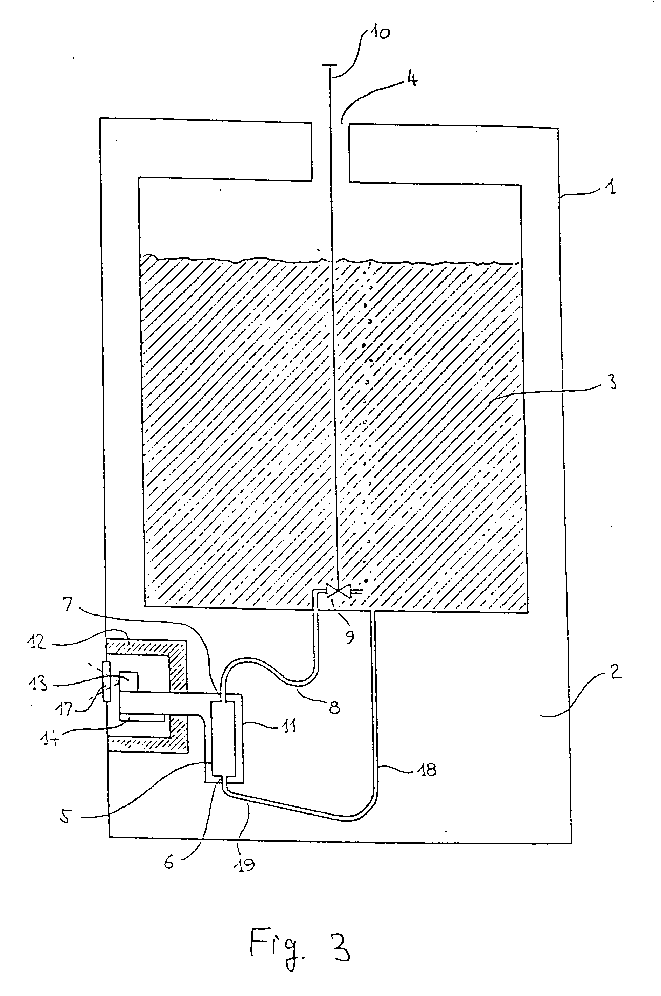

In Fig. 2 ist eine besondere Ausgestaltung der in Fig. 1 geoffenbarten erfindungsgemäßen Kühlvorrichtung dargestellt, bei der die Verdampfungskammer 5 vom Stickstoffvorrat 3 getrennt ist. Hierzu befindet sich die Verdampfungskammer 5 vorteilhafterweise unterhalb des Stickstoffvorrates 3. Vom untersten Niveau des Stickstoffvorrates führt eine Flüssiggaszuleitung 18 zum unteren Ende der Verdampfungskammer 5. Der in der Verdampfungskammer 5 verdampfte flüssige Stickstoff entweicht über eine Dampfableitung 8 und über eine Drossel 9 in den Stickstoffvorrat 3. Im übrigen sind der Aufbau und die Funktionsweise dieser Kühlvorrichtung bis auf eine den veränderten Umständen angepaßte Wärmeisolierung 12 identisch mit der in Fig. 1 dargestellten Ausführungsform. Ein besonderer Vorteil der in Fig. 2 dargestellten Ausführungsform besteht jedoch darin, daß fast der gesamte Stickstoffvorrat 3 zur Erzeugung der Kühlleistung in die Verdampfungskammer 5 eingeleitet werden kann.

Ein weiterer Vorteil besteht darin, daß durch die weitgehend beliebig formbaren Leitungen, die Flüssiggaszuleitung 18 und die Dampfableitung 8, die Verdampfungskammer 5 mit dem Kühlfinger 11 an eine für den weiteren optischen Aufbau günstige Position gebracht werden kann.

In Fig. 3 ist eineweitere Ausgestaltung der in Fig. 2 geoffenbarten erfindungsgemäßen Kühlvorrichtung dargestellt, bei der die Flüssiggaszuleitung 18 und die Dampfableitung 8 aus wärmeisolierendem Material bestehen und die Verdampfungskammer 5 in das Innere des Kühlfingers 11 verlegt ist. Bei dieser Ausgestaltung kann bei hohen Temperaturen des Kühlfingers der flüssige Stickstoff bereits im verdamfungskammerseitigen Ende 19 der Flüssiggaszuleitung 18 verdampfen. Um sicherzustellen, daß das Gas auch dann nur durch die Dampfableitung 8 entweicht, muß das Ende 19 der Flüssiggaszuleitung 18 nach oben geneigt sein.

Es soll ausdrücklich darauf hingewiesen werden, daß diese Kühlvorrichtung mit allen Arten von Kryoflüssigkeiten betrieben werden kann und sich insbesondere die Wahl einer geeigneten Kryoflüssigkeit nach dem Temperaturbereich richtet, in dem die Betriebstemperatur des Diodenlasers 13 oder eines sonstigen Bauelementes zu variieren ist. Darüberhinaus kann der Kryoflüssigkeitsvorratsbehälter 1 auch auf andere Weise als nach Art eines Dewargefäßes ausgebildet sein, sofern nur eine gute Wärmeisolierung gewährleistet ist. Wie auch in den Ansprüchen zum Ausdruck gebracht wurde, kann diese Kühlvorrichtung nicht nur beim Betrieb von Diodenlasern eingesetzt werden, sondern kann überall dort Verwendung finden, wo optische und/oder elektronische Bauelemente oder sonstige Proben in einem weiteren Temperaturbereich auf eine gewünschte Temperatur abgekühlt werden sollen.

### Bezugszeichenliste

- 1: Vorratsbehälter für die Kryoflüssigkeit
- 2: Isoliervakuum
- 3: Kryoflüssigkeitsvorrat
- 4: Einfüllöffnung für die Kryoflüssigkeit
- 5: Verdampfungskammer
- 6: untere Öffnung der Verdampfungskammer (Eintrittsöffnung)
- 7: obere Öffnung der Verdampfungskammer (Austrittsöffnung)
- 8: Dampfableitung
- 9: Drossel
- 10: mechanische Vorrichtung zur Betätigung der Drossel
- 11: Kühlfinger
- 12: Wärmeisolierung
- 13: Diodenlaser
- 14: Heizung
- 15: Temperatursensor
- 16: Elektrische Versorgungsleitungen
- 17: Fenster
- 18: Flüssiggaszuleitung
- 19: Zur Verdampfungskammer führender Endabschnitt der Flüssigkeitszuleitung 18

## Patentansprüche

1. Vorrichtung zur Kühlung von Elementen wie optischen und/oder elektronischen Komponenten, z.B. Diodenlasern, und/oder sonstigen Proben mit einem Vorratsbehälter (1) für eine Kryoflüssigkeit (3), die einer Verdampfungskammer (5) zugeführt wird, in der sie vollständig verdampft, wodurch dem Element (13) Wärme entzogen wird,
wobei die Verdampfungskammer (5) in ihrem unteren Bereich eine Eintrittsöffnung (6) aufweist, durch die die Kryoflüssigkeit aufgrund der Schwerkraft in die Verdampfungskammer (5) eintritt und in ihrem oberen Bereich eine Austrittsöffnung (7) aufweist, durch die der Dampf über eine Drossel (9), mit der der Dampffluß auf einen konstanten, von der hydrostatischen Druckdifferenz zwischen dem Druck der Kryoflüssigkeit an der Drossel (9) und dem Niveau in der Verdampfungskammer (5) abhängenden Wert einstellbar ist, in den Kryoflüssigkeitsvorrat (3) entweicht, wobei das zu kühlende Element (13) mit einem Wärmeleitelement (11) wärmeleitend verbunden ist, das einen geringen Wämewiderstand hat, und das derart in die Verdampfungskammer (5) hineinragt, daß die Kryoflüssigkeit in der Verdampfungskammer (5) das Wärmeleitelement (11) benetzt, und wobei das Wärmeleitelement (11) gegen den Kryoflüssigkeitsvorratsbehälter (1) thermisch isoliert ist.

2. Vorrichtung nach Anspruch 1,
**dadurch gekennzeichnet,**
daß die Verdampfungskammer (5) im Innern des Kryoflüssigkeitvorrates (3) angeordnet ist, daß die Innenseite des Kryoflüssigkeitvorratsbehälters (1) eine Begrenzungswand der Verdampfungskammer(5) bildet und daß die Verdampfungskammer (5) an ihrem unteren Ende offen ist.

3. Vorrichtung nach Anspruch 1,
**dadurch gekennzeichnet,**
daß die Verdampfungskammer (5) außerhalb des Kryoflüssigkeitvorrates (3) angeordnet ist, daß zwischen dem unteren Ende der Verdampfungskammer (5) und dem Kryoflüssigkeitsvorrat (3) eine der Verdampfungskammer (5) die Kryoflüssigkeit zuleitende Verbindung (18) besteht, daß zwischen dem oberen Ende der Verdampfungskammer (5) und dem Kryoflüssigkeitsvorrat (3) eine den Dampf in den Kryoflüssigkeitsvorrat (3) leitende Verbindung (8) besteht, und daß der Dampf vor dem Eintritt in den Kryoflüssigkeitsvorrat (3) die Drossel (9) passiert.

4. Vorrichtung zur Kühlung von Elementen wie optischen und/oder elektronischen Komponenten, z.B. Diodenlasern, und/oder sonstigen Proben mit einem Vorratsbehälter (1) für eine Kryoflüssigkeit (3), die einer Verdampfungskammer (5) mittels einer Zuleitung (18) zugeführt wird, in der sie vollständig verdampft, wodurch dem Element (13) Wärme entzogen wird,
wobei die Verdampfungskammer (5) in ihrem unteren Bereich eine Eintrittsöffnung (6) aufweist, durch die die Kryoflüssigkeit aufgrund der Schwerkraft in die Verdampfungskammer (5) eintritt, und die in ihrem oberen Bereich eine Austrittsöffnung (7) aufweist, durch die der Dampf über eine Drossel (9), mit der der Dampffluß auf einen konstanten von der hydrostatischen Druckdifferenz zwischen dem Druck der Kryoflüssigkeit an der Drossel (9) und dem Niveau in der Verdampfungskammer (5) bzw. der Zuleitung (18) abhängenden Wert einstellbar ist, in den Kryoflüssigkeitsvorrat (3) entweicht,
wobei das zu kühlende Element (13) mit einem Wärmeleitelement (11) wärmeleitend verbunden ist, das einen geringen Wärmewiderstand hat,
wobei die Verdampfungskammer (5) als Hohlraum im Innern des Wärmeleitelements (11) ausgebildet ist, und
wobei das Wärmeleitelement (11) gegen den Kryoflüssigkeitsvorratsbehälter (1) thermisch isoliert ist.

5. Vorrichtung nach Anspruch 4,
**dadurch gekennzeichnet**,
daß zwischen dem unteren Ende der Verdampfungskammer (5) und dem Kryoflüssigkeitsvorrat (3) eine der Verdampfungskammer (5) die Kryoflüssigkeit zuleitende Verbindung (18) besteht, daß zwischen dem oberen Ende der Verdampfungskammer (5) und dem Kryoflüssigkeitsvorrat (3) eine den Dampf in den Kryoflüssigkeitsvorrat (3) leitende Verbindung (8) besteht, und daß der Dampf vor dem Eintritt in den Kryoflüssigkeitsvorrat (3) die Drossel (9) passiert.

6. Vorrichtung nach Anspruch 3 oder 5,
**dadurch gekennzeichnet**,
daß die Flüssiggaszuleitung (18) vom unteren Ende des Kryoflüssigkeitsvorrates (3) ausgeht.

7. Vorrichtung nach einem der Ansprüche 1, 3 bis 6,
**dadurch gekennzeichnet,**
daß das obere Ende der Verdampfungskammer (5) tiefer liegt als das unterste Niveau des Kryoflüssigkeitsvorrates (3).

8. Vorrichtung nach einem der Ansprüche 1,3-7,
**dadurch gekennzeichnet**,
daß sich die Drossel (9) außerhalb des Kryoflüssigkeitsvorrates (3) befindet.

9. Vorrichtung nach einem der Ansprüche 1 - 7,
**dadurch gekennzeichnet,**
daß sich die Drossel (9) innerhalb des Kryoflüssigkeitsvorrates (3) befindet.

10. Vorrichtung nach einem der Ansprüche 1 - 9,
**dadurch gekennzeichnet,**
daß die Drossel (9) durch die Kryoflüssigkeitseinfüllöffnung (4) betätigbar ist.

11. Vorrichtung nach einem der Ansprüche 1 - 10,
**dadurch gekennzeichnet,**
daß die Drossel (9) während des Betriebes des Elementes (13), z.B. eines Diodenlasers, einstellbar ist.

12. Vorrichtung nach einem der Ansprüchen 1 - 11,
**dadurch gekennzeichnet,**
daß der Kryoflüssigkeitsvorratsbehälter (1) als Dewargefäß ausgebildet ist, und daß das Element (13), z.B. ein Diodenlaser, im Isoliervakuum (2) zwischen den das Dewargefäß bildenden Wänden oder in einer auf sonstige Weise wärmeisolierten Umgebung angeordnet ist.

13. Vorrichtung nach einem der Ansprüche 1 - 12,
**dadurch gekennzeichnet**,
daß das Element (13), z.B. ein Diodenlaser, elektrisch beheizbar ist, und daß die Betriebstemperatur des Elementes (13) bei durch Voreinstellung der Drossel (9) vorgegebener Kühlleistung durch Variation der Heizleistung regelbar ist.

14. Vorrichtung nach einem der Ansprüche 1 - 12,
**dadurch gekennzeichnet,**
daß das Element (13), z.B. ein Diodenlaser, elektrisch beheizbar ist und daß die Betriebstemperatur des Elementes bei vorgegebener Heizleistung durch Variation der über die Drossel (9) einstellbaren Kühlleistung regelbar ist.

15. Vorrichtung nach Anspruch 13 oder 14,
**dadurch gekennzeichnet,**
daß ein Temperatursensor (15) an dem Element (13) vorgesehen ist, der die Temperatur des Elementes (13) erfaßt.

16. Vorrichtung nach einem der Ansprüche 1 - 15,
**dadurch gekennzeichnet,**
daß mehrere Elemente (13) gleicher oder unterschiedlicher Art kühlbar sind und daß die Elemente (13) über einzelne voneinander thermisch isolierte Wärmeleitelemente mit gleichem und/oder unterschiedlichem Wärmewiderstand mit dem Hauptwärmeleitelement (11) verbunden sind.

17. Vorrichtung nach einem der Ansprüche 1 - 3 sowie 7 - 15 in der Rückbeziehung auf einen der Ansprüche 1 - 3,
**dadurch gekennzeichnet**,
daß mehrere Elemente (13) gleicher oder unterschiedlicher Art kühlbar sind und daß die Elemente (13) an einzelne voneinander thermisch isolierte Wärmeleitelemente (11) mit gleichem und/oder unterschiedlichem Wärmewiderstand angeschlossen sind und daß die Wärmeleitelemente (11) in voneinander getrennte Verdampfungskammern gleicher und/oder unterschiedlicher Ausführung hineinragen.

18. Vorrichtung nach einem der Ansprüche 1 - 17,
**dadurch gekennzeichnet,**
daß die jeweilige Betriebstemperatur des Elementes (13) im Bereich von Temperaturen von knapp oberhalb der Siedetemperatur der jeweiligen Kryoflüssigkeit bis über Raumtemperatur einstellbar ist.

## Claims

1. Device for cooling elements such as optical and/or electronic components, e.g. diode lasers, and/or miscellaneous test pieces with a storage container (1) for a cryofluid (8), which is supplied to an evaporating chamber (5) in which it is completely evaporated, so that heat is extracted from the element (13), the evaporating chamber (5) having in its lower area an inlet opening (6) through which the cryofluid enters the evaporating chamber (5) as a result of gravity and at its upper end has an outlet opening (7), through which the vapour escapes into the cryofluid supply (3) by means of a restrictor (9), with which the vapour flow can be adjusted to a constant value dependent on the hydrostatic pressure difference between the pressure of the cryofluid at the restrictor (9) and the level in the evaporating chamber (5), the element (13) to be cooled being connected in heat conducting manner to a heat conducting element (11), which has a low thermal resistance and which projects in such a way into the evaporating chamber (5) that the cryofluid in the evaporating chamber (5) wets the heat conducting element (II) and in which the latter is thermally insulated against the cryofluid storage container (1).

2. Device according to claim 1, characterized in that the evaporating chamber (5) is located in the interior of the cryofluid supply (3), that the inside of the cryofluid storage container (1) forms a boundary wall of the evaporating chamber (5) and that the lower end of the evaporating chamber (5) is open.

3. Device according to claim 1, characterized in that the evaporating chamber (5) is located outside the cryofluid supply (3), that between the lower end of the evaporating chamber (5) and the cryofluid supply (3) there is a line (18) supplying the cryofluid to the evaporating chamber (5), that between the upper end of the evaporating chamber (5) and the cryofluid supply (3) is a line (8) passing vapour into the cryofluid supply (3) and that the vapour passes through a restrictor (9) before entering the cryofluid supply (3).

4. Device for cooling elements such as optical and/or electronic components, e.g. diode lasers, and/or miscellaneous test pieces with a storage container (1) for a cryofluid (3), which is supplied to an evaporating chamber (5) in which it is completely evaporated, so that heat is extracted from the element (13), the evaporating chamber (5) having in its lower area an inlet opening (6) through which the cryofluid enters the evaporating chamber (5) as a result of gravity and at its upper end has an outlet opening (7), through which the vapour escapes into the cryofluid supply (3) by means of a restrictor (9), which which the vapour flow can be adjusted to a constant value dependent on the hydrostatic pressure difference between the pressure of the cryofluid at the restrictor (9) and the level in the evaporating chamber (5), the element (13) to be cooled being connected in heat conducting manner to a heat conducting element (11), which has a low thermal resistance, in which the evaporating chamber (5) is constructed as a cavity in the interior of the heat conducting element (11) and in which the heat conducting element (11) is thermally insulated against the cryofluid supply container (1).

5. Device according to claim 4, characterized in that between the lower end of the evaporating chamber (5) and the cryofluid supply (3) there is a line (18) supplying the cryofluid to the evaporating chamber (5), that between the upper end of the evaporating chamber (5) and the cryofluid supply (3) there is a line (8) passing vapour to the cryofluid supply (3) and that the vapour passes through a restrictor (9) before entering the cryofluid supply (3).

6. Device according to claim 3 or 5, characterized in that the liquid gas supply line (18) emanates from the lower end of the cryofluid supply (3).

7. Device according to one of the claims 1, 3 to 6, characterized in that the upper end of the evaporating chamber (5) is lower than the bottom level of the cryofluid supply (3).

8. Device according to one of the claims 1, 3 to 7, characterized in that the restrictor (9) is located outside the cryofluid supply (3).

9. Device according to one of the claims 1 to 7, characterized in that the restrictor (9) is located within the cryofluid supply (3).

10. Device according to one of the claims 1 to 9, characterized in that the restrictor (9) is operable through the cryofluid filling opening (4).

11. Device according to one of the claims 1 to 10, characterized in that the restrictor (9) is adjustable during the operation of the element (13), e.g. a diode laser.

12. Device according to one of the claims 1 to 11, characterized in that the cryofluid storage container (1) is constructed as a Dewar flask and that the element (13), e.g. a diode laser, is located in the insulating vacuum (2) between the walls forming the Dewar flask or in an environment thermally insulated in some other way.

13. Device according to one of the claims 1 to 12, characterized in that the element (13), e.g. a diode laser, is electrically heatable and that the operating temperature of the element (13) can be regulated by varying the thermal capacity for a given cooling capacity resulting from the presetting of the restrictor (9).

14. Device according to one of the claims 1 to 12, characterized in that the element (13), e.g. a diode laser, is electrically heatable and that the operating temperature of the element for a given heating capacity is regulatable by varying the cooling capacity settable via the restrictor (9).

15. Device according to claim 13 or 14, characterized in that a temperature sensor (15) is provided on the element (13) and determines its temperature.

16. Device according to one of the claims 1 to 15, characterized in that several elements (13) of the same or a different nature can be cooled and that the elements (13) are connected by means of individual, mutually thermally insulated heat conducting elements with the same and/or different thermal resistance to the main heat conducting element (11).

17. Device according to one of the claims 1 to 3, as well as 7 to 15 dependent on one of the claims 1 to 3, characterized in that several elements (13) of the same or different nature can be cooled and that the elements (13) are connected to individual, mutually thermally insulated heat conducting elements (11) with the same and/or different thermal resistance and that the heat conducting elements (11) project into separate evaporating chambers having the same and/or a different construction.

18. Device according to one of the claims 1 to 17, characterized in that the operating temperature of the element (13) can be adjusted within the range of temperatures from just above the boiling point of the particular cryofluid to above ambient temperature.

## Revendications

1. Appareil de refroidissement pour éléments comme des composants optiques et/ou électroniques, par exemples des lasers à injections, et/ou des autres éprouvettes, à un réservoir (1) contenant un liquide cryogénique (3) qui est alimenté à une chambre d'évaporation (5), où il est évaporé complètement, en absorbant de chaleur dudit élément (13),
dans lequel ladite chambre d'évaporation (5) comprend une ouverture d'admission (6) dans sa région inférieure, par laquelle ledit liquide cryogénique entre, par gravité, dans ladite chambre d'évaporation (5), et une ouverture de sortie (7) dans sa région supérieure, par laquelle la vapeur s'échappe dans le stock en liquide cryogénique (3) via un étrangleur (9), moyennant lequel le flux de vapeur est ajustable à une valeur constante, qui dépend de la différence de pression hydrostatique entre la pression dudit liquide cryogénique audit étrangleur (9) et le niveau régnant dans ladite chambre d'évaporation (5), dans lequel ledit élément (13) à refroidir est relié, de façon thermoconductrice, à un élément conducteur de chaleur (11), à basse résistance thermique, qui fait saillie dans ladite chambre d'évaporation (5) de manière que ledit liquide cryogénique dans ladite chambre d'évaporation mouille ledit élément conducteur de chaleur (11), et dans lequel ledit élément conducteur de chaleur (11) est isolé de la chaleur dudit réservoir de liquide cryogénique (1).

2. Appareil selon la revendication 1,
**caractérisé en ce**
que ladite chambre d'évaporation (5) est disposée à l'intérieur dudit stock en liquide cryogénique (3), en ce que la face intérieure dudit réservoir de liquide cryogénique (1) constitue une paroi périphérique de ladite chambre d'évaporation (5), et en ce que ladite chambre d'évaporation (5) est ouverte à son extrémité inférieure.

3. Appareil selon la revendication 1,
**caractérisé en ce**
que ladite chambre d'évaporation (5) est disposée en dehors dudit stock en liquide cryogénique (3), en ce qu'il y a une communication (18) d'admission dudit liquide cryogénique à ladite chambre d'évaporation (5), entre l'extrémité inférieure de ladite chambre d'évaporation (5) et ledit stock en liquid cryogénique (3), en ce qu'il y a une communication (8) entre l'extrémité supérieure de ladite chambre d'évaporation (5) et ledit stock en liquide cryogénique (3), qui introduit la vapeur dans ledit stock en liquide cryogénique, et en ce que la vapeur passe à travers ledit étrangleur (9) avant qu'elle entre dans ledit stock en liquide cryogénique (3).

4. Appareil de refroidissement pour éléments comme des composants optiques et/ou électroniques, par exemples des lasers à injections, et/ou des autres éprouvettes, à un réservoir (1) contenant un liquide cryogénique (3) qui est alimenté à une chambre d'évaporation (5), où il est évaporé complètement, en absorbant de chaleur dudit élément (13),
dans lequel ladite chambre d'évaporation (5) comprend une ouverture d'admission (6) dans sa région inférieure, par laquelle ledit liquide cryogénique entre, par gravité, dans ladite chambre d'évaporation (5), et une ouverture de sortie (7) dans sa région supérieure, par laquelle la vapeur s'échappe dans le stock en liquide cryogénique (3) via un étrangleur (9), moyennant lequel le flux de vapeur est ajustable à une valeur constante, qui dépend de la différence de pression hydrostatique entre la pression dudit liquide cryogénique audit étrangleur (9) et le niveau régnant dans ladite chambre d'évaporation (5),
dans lequel ledit élément (13) à refroidir est relié, de façon thermoconductrice, à un élément conducteur de chaleur (11), à basse résistance thermique, dans lequel ladite chambre d'évaporation (5) est configurée sous forme d'un creux à l'intérieur dudit élément conducteur de chaleur (11), et
dans lequel ledit élément conducteur de chaleur (11) est isolé de la chaleur dudit réservoir de liquide cryogénique (1).

5. Appareil selon la revendication 4,
**caractérisé en ce**
qu'il y a une communication (18) d'admission dudit liquide cryogénique à ladite chambre d'évaporation (5), entre l'extrémité inférieure de ladite chambre d'évaporation (5) et ledit stock en liquide cryogénique (3), en ce qu'il y a une communication (8) entre l'extrémité supérieure de ladite chambre d'évaporation (5) et ledit stock en liquide cryogénique (3), qui introduit la vapeur dans ledit stock en liquide cryogénique, et en ce que la vapeur passe à travers ledit étrangleur (9) avant qu'elle entre dans ledit stock en liquide cryogénique (3).

6. Appareil selon la revendication 3 ou 5,
**caractérisé en ce**
que ladite communication d'admission de gaz liquéfié départ de ladite extrémité inférieure dudit stock en liquide cryogénique (3).

7. Appareil selon une quelconque des revendications 1, 3 à 6,
**caractérisé en ce**
que ladite extrémité supérieure de ladite chambre d'évaporation (5) se trouve à un niveau au dessous du niveau plus bas dudit stock en liquide cryogénique (3).

8. Appareil selon une quelconque des revendications 1, 3 à 7,
**caractérisé en ce**
que ledit étrangleur (9) se trouve en dehors dudit stock en liquide cryogénique (3).

9. Appareil selon une quelconque des revendications 1 à 7,
**caractérisé en ce**
que ledit étrangleur (9) se trouve au sein dudit stock en liquide cryogénique (3).

10. Appareil selon une quelconque des revendications 1 à 9,
**caractérisé en ce**
que ledit étrangleur (9) est commandable par l'ouverture de remplissage (4) dudit liquide cryogénique.

11. Appareil selon une quelconque des revendications 1 à 10,
**caractérisé en ce**
que ledit étrangleur (9) est ajustable pendant l'opération dudit élément (13), par exemple un laser à injections.

12. Appareil selon une quelconque des revendications 1 à 11,
**caractérisé en ce**
que ledit réservoir (1) de liquide cryogénique est configuré sous forme d'un vase Dewar, et en ce que ledit élément (13), par exemple un laser à injections, est disposé dans le vide isolant (2) entre les parois, qui définissent led vase Dewar, ou dans un milieu isolé de la chaleur de toute autre façon quelconque.

13. Appareil selon une quelconque des revendications 1 à 12,
**caractérisé en ce**
que ledit élément (13), par exemple un laser à injections, est chauffable, de façon électrique, et en ce que la température de service dudit élément (13) est réglable, en variant la puissance calorifique, à puissance frigorifique déterminée par préréglage dudit étrangleur (9).

14. Appareil selon une quelconque des revendications 1 à 12,
**caractérisé en ce**
que ledit élément (13), par exemple un laser à injections, est chauffable, de façon électrique, et en ce que la température de service dudit élément est réglable, en variant la puissance frigorifique ajustable moyennant ledit étrangleur, à puissance calorifique déterminée.

15. Appareil selon la revendications 13 ou 14,
**caractérisé en ce**
qu'une sonde pyrométrique (15) est prévue audit élément (13), qui détecte la température dudit élément (13).

16. Appareil selon une quelconque des revendications 1 à 15,
**caractérisé en ce**
qu'une pluralité desdits éléments (13), de genre similaire ou différent, est refroidissable, et en ce que lesdits éléments (13) sont raccordés audit élément conducteur de chaleur principal (11) via des éléments conducteurs de chaleur individuels, isolés l'un de l'autre de façon thermique, à résistance thermique similaire et/ou différente.

17. Appareil selon une quelconque des revendications 1 à 3 et 7 à 15, en leur dépendance sur une quelconque des revendications 1 à 3,
**caractérisé en ce**
qu'un pluralité desdits éléments (13), de genre similaire ou différent, est refroidissable, et en ce que lesdits éléments (13) sont raccordés à des éléments conducteurs de chaleur individuels, isolés l'un de l'autre de façon thermique, à résistance thermique similaire et/ou différente, et en ce que lesdits éléments conducteurs de chaleur (11) font saillie dans des chambres d'évaporation séparées l'une de l'autre, à configuration similaire et/ou différente.

18. Appareil selon une quelconque des revendications 1 à 17,
**caractérisé en ce**
que la température de service respective dudit élément (13) est ajustable dans la gamme de températures entre un niveau juste au dessus de la température d'ébullition du liquide cryogénique respectif et un niveau juste au dessus de la température ambiante.
